# EUROPEAN PATENT SPECIFICATION

(11) **EP 2 306 230 B1**
(45) Date of publication and mention of the grant of the patent: **21.12.2011**
(21) Application number: 09012409.0
(22) Date of filing: 30.09.2009
(51) Int. Cl.: G02B 13/06, G02B 3/00, H04N 5/335

(54) **Method for fabricating an artificial compound eye**
Verfahren zur Herstellung eines künstliches Facettenauges
Procédé de fabrication d'un oeil composé artificiel

(43) Date of publication of application: 06.04.2011
(73) Proprietor: Fraunhofer-Gesellschaft zur Förderung der angewandten Forschung e.V., 80686 München (DE); Ecole Polytechnique Fédérale de Lausanne, 1015 Lausanne (CH); Université de la Méditerranée - Aix-Marseille II, 13284 Marseille Cedex 07 (FR)
(72) Inventor: Duparré, Jacques, 07745 Jena (DE); Brückner, Andreas, 07743 Jena (DE); Wippermann, Frank, 98617 Meiningen (DE); Zufferey, Jean-Christophe, 1024 Ecublens (CH); Floreano, Dario, 1031 Mex (CH); Franceschini, Nicolas, 13009 Marseille (FR); Viollet, Stephane, 13006 Marseille (FR); Ruffier, Franck, 13006 Marseille (FR)
(74) Representative: Zimmermann, Tankred Klaus

(56) References cited:
- EP-A2- 2 088 572
- WO-A-99/26419
- WO-A-2005/069607
- JP-A- 2003 283 932
- US-A1- 2006 044 451
- VOLKEL R ET AL: "Miniaturized imaging systems" MICROELECTRONIC ENGINEERING, ELSEVIER PUBLISHERS BV., AMSTERDAM, NL, vol. 67-68, 1 June 2003 (2003-06-01), pages 461-472, XP004428906 ISSN: 0167-9317
- SAITO H ET AL: "Compound eye shaped flexible organic image sensor with a tunable visual field" MICRO ELECTRO MECHANICAL SYSTEMS, 2005. MEMS 2005. 18TH IEEE INTERNATI ONAL CONFERENCE ON MIAMI BEACH, FL, USA JAN. 30 - FEB. 3, 2005, PISCATAWAY, NJ, USA,IEEE, 30 January 2005 (2005-01-30), pages 96-99, XP010811668 ISBN: 978-0-7803-8732-4

## Description

The present invention relates to a method for fabrication of an imaging system which may be used as an artificial compound eye.

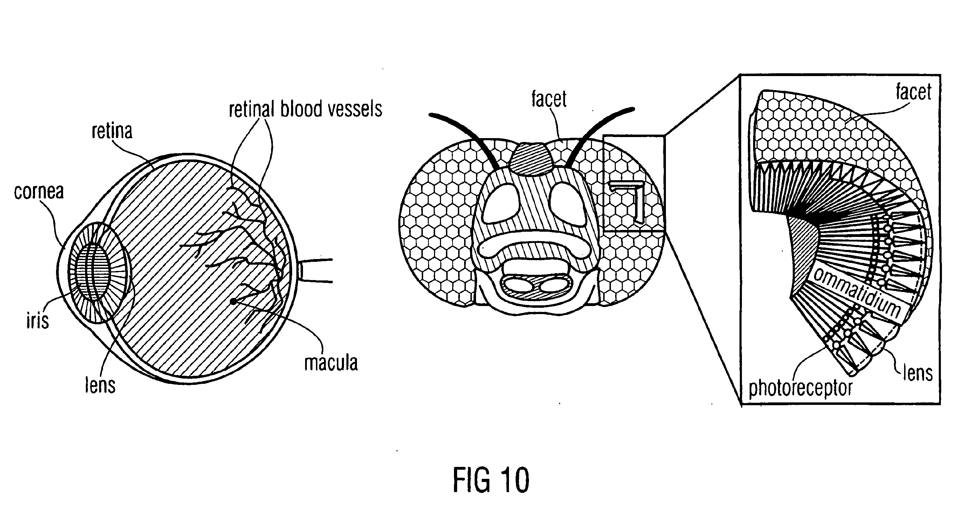

The vertebrate eye (Fig. 10, left) has provided inspiration for the design of conventional cameras, which consist of a planar image sensor in the focal plane of single-aperture optics (single or multiple co-axial lenses). Their purpose is to provide a faithful rendering of the visual world that can be processed by image analysis algorithms for a large variety of purposes, especially for object recognition. However, such vision systems require complex and fast computation in order to extract motion-related information from a sequence of high-resolution images. The insect compound eye (Fig. 10, centre and right), instead, consists of a curved array of microlenses, each conveying photons to a separate set of one or more photoreceptors. Although the compound eye design offers a comparatively lower resolution than the vertebrate eye, it is very efficient for local and global motion analysis over a large field-of-view (FOV), making it an excellent sensor for accurate and fast navigation in 3D dynamic environments. Furthermore, compound eyes take several shapes and curvatures to fit the head and viewing directions of very different types of insects while offering the same functionality.

Artificial vision systems inspired upon the insect compound eye will be a radically different alternative to conventional cameras and will provide more efficient visual abilities for embedded applications that require motion analysis in low-power and small packages; artificial compound eyes could also adapt to different shapes and curvatures to fit the application requirements. However, the design of artificial compound eyes presents several technological and scientific challenges because it drastically departs from the design of conventional cameras for what concerns the components, fabrication procedures, packaging, and visual processing.

Miniaturized cameras are important features for next-generation customer products. Digital micro-cameras, which are based on miniaturized classical lens designs, are rarely smaller than 4 x 4 x 3 mm³ for a VGA (Video Graphics Array) with approximately 60° field-of-view. Recent improvements of CMOS (Complementary Metal Oxide Semiconductor) image sensors could allow further miniaturization, but the shrinking pixel size will lead to further loss of sensitivity. Furthermore the thickness of conventional imaging optics is typically in the same order of magnitude as is their focal length. The digital sensor diagonal and the given field-of-view determine the required magnification of the lens. For a conventional lens this magnification is defined by its focal length, while for compound eyes it is not. This is why artificial compound eyes could be much thinner than classical cameras for the same magnification. Furthermore, in compound eyes each channel could be individually tuned for its specific viewing direction - large fields of view are possible without major change in the axial arrangement while in classical lens designs large fields of view require increasingly more lenses in the axial stack ("fish-eye") which increases the objective thickness dramatically. Consequently a simple scaling of the classical imaging approach to the desired size has drawbacks. Furthermore, high-resolution images are not always required. Often the main aim is a compact, robust and cheap vision system performing only a very specific task, but at extremely high speed, such as motion detection, distance estimation, or vision-based stabilization. When these tasks are performed with high resolution conventional cameras, large field-of-view and complex image processing are often required, which translate into thick optics and power-consuming computing devices that are often larger than the optoelectronic device itself.

There are different ways to enlarge the field-of-view of an imaging system. One common approach is to use omni-directional cameras composed of a mirror and of a conventional camera (see Gluckman, J. and Nayar, S.K. (1998) Ego-Motion and Omnidirectional Cameras, Int. Conference on Computer Vision, pp 999-1005; Vassallo, R.F., Santos-Victor, J. and Schneebeli, H.J. (2002) A general approach for egomotion estimation with omnidirectional images, OMNIVIS'02 Workshop on Omni-directional Vision, pp97-103; Mei, C. and Rivers, P. (2007) Single view point ominidirectional camera calibration, IEEE Conf. On Robotics and Automation, pp 3945-3950), resulting in a catadioptric imaging system. Such a system has two constraints. One of them lies in the fact that the lens and the mirror have to be precisely aligned in order to have a single centre of projection generating pure perspective images. The other constraint is the large weight and size occupied by such a system.

Another approach is to use fish-eye lenses (see Courbon, J., Mezouar, Y., Eck, L. and Martinet, P. (2007) A generic fisheye camera model for robotic applications, Int. Conf. on Intelligent Robots and Systems, pp 1683-1688) instead of a reflecting surface. The associated problem is that the viewed scene has large distortions. Hence it is difficult to calibrate the sensor and the acquired image must be rectified for further visual processing.

Using several cameras looking into different directions offers a further possibility for generating omnidirectional view. For example, the Argus Eye (see Baker, E., Ogale, P., Ferm-ller, C. and Aloimonos, Y. (2004) A spherical eye from multiple cameras (makes better models of the world), IEEE Robotics and Automation Magazine: Special Issue on Panoramic Robots 11(4), pp 31-38) uses a network of cameras, with each of them occupying a different part of the visual sphere. Although the underlying calibration and visual processing of the Argus Eye system is straightforward, it needs high-resolution cameras for the accurate recovery of motion information and hence has a high computational demand.

A recent approach combined several optical mouse chips to cover a wide field-of-view (Dahmen, H., Millers, A. and Mallot, H.A. (2009) Insect inspired odometry by optic flow recorded with optical mouse chips, to appear in Flying Robots and Insects, Springer Verlag; Beyeler, A., Zufferey, J.-C. and Floreano, D. (2009) Vision-based control of near-obstacle flight. Submitted to the Journal of Autonomous Robots, special issue on Visual Guidance Systems for Small Unmanned Aerial Vehicles). These imagers have an onchip signal processor that correlates two consecutive images. The limitation of this approach is that each mouse sensor can extract only a single displacement between two images instead of the full pattern of optic flow available over the entire field-of-view. Furthermore the entire vision system composed of 5 or more mouse sensors with their own optics is relatively bulky and heavy.

The newly gained spectrum of technological capabilities is now raising the question of which vision principle and technology is most suitable for the acquisition of the desired information at the desired level of miniaturization. A fascinating approach is to study how nature successfully solved similar problems in the case of very small creatures. In particular, flying insects are an interesting source of inspiration for miniaturized vision systems because they have some of the most stringent constraints in size and energy consumption and their survival is largely dependent on vision-based behaviors.

Insect compound eyes display high temporal resolution, small volumes, and large fields of view at the cost of comparatively low angular resolution (see Land, M. (1997) Visual Acuity in Insects. Annual Review of Entomology, 42, 147-177). For small invertebrates, such as flies or honeybees, the compound eyes are a perfect solution for quickly obtaining visual information about the environment without overloading their brain with complex image processing. A biological apposition compound eye consists of an array of microlenses on a curved surface. Each microlens is associated with a small group of photoreceptors in its focal plane. Apposition compound eyes have mainly evolved in diurnal insects such as flies (Horridge, G., A. (1977) The compound eye of insects. Sci. Am., 237 pp. 108-120). A single microlens-photoreceptor unit forms one optical channel and is commonly referred to as ommatidium (Kirschfeld, K. (1974) The absolute sensitivity of lens and compound eyes. Z. Naturforsch., 29 pp. 592-596; see also Fig. 10, right). Gradient refractive index cones and pigments, which form opaque walls between adjacent ommatidia, prevent light from being focused by a channel's microlens onto an adjacent channel's receptor ("crosstalk"). Natural apposition compound eyes contain from several hundreds (water fly) to tens of thousands (honeybee or Japanese dragon fly) of these ommatidia packed in non-uniform hexagonal arrays (Land, M., and Nilsson, D.-E. (2002) Animal Eyes. Oxford animal biology series, Oxford University Press).

Only very recently micro-optics technology enabled the generation of highly precise and uniform microlens arrays with small lens heights and their alignment to the subsequent aperture arrays with the high accuracy of photolithography. Very recent explorations in insect-inspired optical systems resulted in imaging devices that use an array of microlenses interfaced to a CMOS imager (see Duparré, J. and Wippermann, F. (2006) Micro-optical artificial compound eyes. Bioinspir. Biomim., 1 R1-R16). The great advantage of this novel design, which is a planar version of the apposition compound eye of insects, is that it is ultra-thin, monolithic, comparatively simple and ultra-light weight (Duparré, J., Dannberg, P., Schreiber, P., Bräuer, A. and Tünnermann, A. (2004) Artificial apposition compound eye fabricated by micro-optics technology. Applied Optics, 43(22) pp. 4303-4310; Duparré, J., Dannberg, P., Schreiber, P., Bräuer, A. and Tünnermann, A. (2005) Thin compound eye camera. Applied Optics, 44(15) pp. 2949-2956). In past demonstrations however, only conventional high-resolution image sensors have been used with planar compound optics and only a small number of pixels have been extracted from those. This resulted in a waste of costly CMOS area due to the sub-optimal coupling of arrays of densely packed small CMOS pixels with arrays of much larger microlenses and in a maximum field-of-view of 65°.

A major drawback with planar compound optics developed so far consists in large off-axis aberrations that occur when imaging under large angles of incidence. This problem was partially addressed in previous work by individually optimizing the microlens shapes for their specific angles of incidence forming a so-called "chirped microlens array" (Duparré, J., Wippermann, F., Dannberg, P. and Reimann, A. (2005) Chirped arrays of refractive ellipsoidal microlenses for aberration correction under oblique incidence. Opt. Exp., 13(26) pp. 10539-10551). However, for large angles of incidence on a planar microlens array, vignetting (reduction of the image brightness or saturation at the periphery compared to the image centre of each microlens) drastically reduces the sensitivity of the device while optical channel crosstalk drastically decreases image contrast. Consequently, the planar compound eye had a restricted field-of-view of about 65°, which is by far less than that of natural compound eyes, which allow almost spherical vision.

A few groups worldwide are currently working on highly advanced components that could serve as starting points for future curved artificial compound eyes. Radtke, D., Duparré, J., Zeitner, U. and Tünnermann, A. (2007) Laser lithographic fabrication and characterization of a spherical artificial compound eye. Opt. Exp., 15(6) pp. 3067-3077, used a refractive microlens array whose master is laser-beam written on a curved substrate and undergo several subsequent replication steps. This technologically challenging scheme is still limited to large radii of curvature of the base substrate leading to a bulky system (several cubic cm) due to a limited tilt angle in the laser beam writer (10°). Since there was no curved image sensor that could be coupled to the micro-optics array, the image was relayed to a planar image sensor by means of an array of transparent pinholes in an opaque curved layer concentric with the lens array and bulky relay optics. Furthermore, the system suffered from crosstalk and a poor light sensitivity.

Another approach (Jeong, K.-H., Kim, J. and Lee, L.P. (2006) Biologically Inspired Artificial Compound Eyes. Science 312, pp. 557-561) suffered from similar problems. Here, several replication processes applying a flexible polydimethylsiloxane (PDMS) membrane and self-guiding effects in the exposed polymers were used to fabricate waveguides resembling the cone-structure of ommatidia with microlenses on the tip that were arranged on a spherical surface. However, also here no integration with a curved photoreceptor array was demonstrated or technologically possible. A more hybrid approach combined fanned out fibers with microlenses on the tip arranged on a spherical surface with the end-tips on a planar image sensor (Hornsey, R., Thomas, P., Wong, W., Pepic, S., Yip, K. and Krishnasamy, R. (2004) Electronic compound eye image sensor: construction and calibration. SPIE International conference on Sensors and Camera Systems for Scientific, Industrial, and Digital Photography Applications V, Vol. 5301, pp. 13-24). Although this solution demonstrated a complete imaging device, achieved a large field-of-view and mechanical rigidness, it combined spherical compound optics with planar image sensor technology, which resulted in a complex macroscopic fabrication and assembly technique, a bulky system, and no spare room within the volume of the eye. A Japanese team attached single lens elements to a matrix of organic field-effect transistors attached on a flexible substrate (Saito, H., Hoshino, K., Matsumoto, K. and Shimoyama, I. (2005) Compound eye shaped flexible organic image sensor with tunable visual field. IEEE International conference on Micro Electro Mechanical Systems, pp. 96-99). They claimed that by manually changing the curvature of the substrate they could obtain a zooming effect. However, the inaccurate method of joining microlenses with photoreceptors led to poor alignment of the ommatidia, thus preventing the extraction of useful visual information.

Flexible, organic image sensors are also currently researched (Xu, X., Davanco, M., Qi, X. and Forrest, S. R. (2008) Direct transfer patterning on three dimensionally deformed surfaces at micrometer resolutions and its application to hemispherical focal plane detector arrays. Organic Electronics 9, pp. 1122-1127), but all suffer from the same problems when need to be combined with microlens arrays with sub-micron precision. An American team recently reported the procedure for producing a curved optoelectronic camera with the shape of a human eye (Ko, H. C., Stoykovich, M. P., Song, J., Malyarchuk, V., Choi, W. M., Yu, C.-J., Geddes, J. B., Xiao, J., Wang, S., Huang,Y. and Rogers, J. A. (2008) A hemispherical electronic eye camera based on compressible silicon optoelectronics. Nature, 454 pp. 748-753; Kim, D.-H., Song, J., Choi, W. M., Kim, H.-S., Kim, R.-H., Liu, Z., Huang, Y. Y., Hwang, K.-C., Zhang, Y.-W. and Rogers, J. A. (2008) Materials and non-coplanar mesh designs for integrated circuits with linear elastic responses to extreme mechanical deformations. PNAS 105 (48) pp. 18675-18680). A key aspect of this device is the flexible wiring between adjacent silicon photoreceptors arranged on a lattice, which allows compression of the lattice. However, the resulting concave silicon optoelectronics is coupled with a single lens, just as in human eyes, and thus sidesteps the alignment and crosstalk problems that would arise when hypothetically coupled to a curved array of microlenses to realize a curved artificial compound eye.

The potential use of these technologies for curved compound eyes presents two additional problems: one problem consists of precisely aligning the curved microlens surface with the curved imaging surface; the other problem is that the processes used for fabricating the vision chip allow for only large and simple sub-pixel structures, thus ruling out the realization of adaptive photoreceptors (such as a VLSI vision chips). Furthermore, although organic optoelectronics are very promising, the pixel elements have relatively low efficiency over the visual spectrum, high dark current and short life cycles due to poorly understood aging processes (Brütting, W. (2005) Physics of Organic Semiconductors. Wiley-VCH).

In summary, what is often claimed as "artificial ommatidia" or "artificial compound eye" in the literature often lacks either the photoreceptors or the optics because the teams are specialized in only one of the two fields or because incompatible technologies are used. Instead, in the case of curved lens or image sensor arrays obtained by applying stress to a deformable PDMS (polydimethylsiloxane) membrane, the resulting device displays poor contour accuracy and repeatability when stretched, which for artificial compound eyes would mean misalignment and thus poor correlation between individual microlenses and photoreceptors that form an ommatidium.

Hence, it is an object of the present invention to provide an improved concept for artificial compound eyes.

The object is solved by a method for fabricating an imaging system according to claim 1.

The technological key to functional and usable curved artificial eyes is a highly accurate alignment of microlenses and photoreceptors to an array of optical channels or ommatidia and the positional and rotational correlation within the array on a common flexible substrate. It is the finding of the present invention that the highly accurate alignment can be achieved when the integration of an optics layer (microlenses) with an optoelectronics layer (photoreceptors) and with a flexible layer is performed in the planar stage and the curvature is introduced at a later stage, when the correlation between the three layers of each ommatidium is fixed.

Embodiments of the present invention provide a method for fabricating an imaging system, the method comprising providing a flexible substrate, providing a first layer comprising a plurality of microlenses and providing a second layer comprising a plurality of image sensors. The first and the second layer are stacked onto the flexible substrate by attaching the plurality of image sensors to the flexible substrate, such that each of the plurality of microlenses and image sensors are aligned to form a plurality of optical channels, each optical channel comprising at least one microlens and an associated image sensor. After the stacking, the optical channels are mechanically separated such that the separated optical channels remain attached to the flexible substrate to form a mechanically flexible imaging system.

According to embodiments, during stacking the first and the second layer onto the flexible substrate, stacking the plurality of microlenses onto the plurality of image sensors is performed before attaching the plurality of image sensors to the flexible substrate. According to embodiments the first and second layer are provided as planar layers, respectively, and stacking the first layer onto the second layer, attaching the stacked first and second layer onto the flexible substrate and mechanically separating the optical channels all occur in a planar state. According to various embodiments, mechanically separating the optical channels may comprise cutting, sawing or etching the stacked first and second layer to physically separate neighbouring optical channels.

Hence, an imaging system, which may serve as a basis for an artificial compound eye, may be obtained by fabricating individual image sensors, e. g., photodiode-pixels, or small groups thereof on an image sensor wafer. Also, corresponding microlens or aperture arrays are fabricated on a microlens or aperture wafer, which may be stacked onto the image sensor wafer by bonding the two together. The resulting wafer stack may be attached to a flexible substrate, which may be a flexible printed circuit board (PCB), e.g. a dicing tape. After attaching the stacked wafers to the flexible substrate, the optical channels or ommatidia ("camera-cubes") are separated by dicing but leaving them on the flexible substrate. After that, a portion of the flexible substrate which shall form the artificial compound eye may be cut out. The obtained flexible imaging system may then be bonded to a convex basis with a desired radius of curvature such that a resulting inter-ommaditial angle is well matched to an acceptance angle of optical individual channels or, in the case of using several image sensors or pixels per microlens, such that the channel is matched to the sampling angle as well. Finally, the image sensors or pixels, are electrically connected to read-out electronics for further data processing.

The flexible substrate may be a flexible PCB (e.g. a dicing tape) wiring out electrical connections of the image sensors or photoreceptors. Electrical connections from the image sensors to the flexible PCB can either be obtained by wire-bonding the image sensors down to electrical interconnections in the flexible PCB, or by connecting the image sensors via "through silicon interconnects" (TSI, e.g. VIAS) at the backsides of the image sensors.

From this results a mechanically flexible imaging system comprising a flexible substrate having attached thereto a plurality of image sensors carrying a plurality of microlenses to form a plurality of optical channels, each optical channel comprising at least one microlens and at least one associated image sensor, and wherein at least some of the optical channels are mechanically separated to form the mechanically flexible imaging system.

Embodiments of the present invention enable the design, prototyping, programming and validation of fully functional artificial compound eyes, which are composed of microlens arrays integrated with adaptive image sensors or photoreceptors, e.g., made of analog very-large-scale-integration circuits (aVLSI), on flexible electronic substrates. The output of the artificial compound eyes may be processed by vision filters implemented in encapsulated programmable devices, such as micro-controllers or field programmable gate arrays (FPGA) for fast extraction of motion-related information.

Compared to conventional cameras, imaging systems fabricated according to embodiments of the present invention may offer much larger field-of-view, nearly infinite depth-of-field (no focusing needed), higher sensitivity, no image blurring and off-axis aberrations, because the distance between the optical surface and the photoreceptors will be constant over the entire field-of view, and because each optical channel will work under perpendicular light incidence for its individual viewing direction. In comparison with classical cameras where focal lengths, spatial resolution and field-of-view are intimately coupled, imaging systems fabricated according to embodiments of the present invention allow the use of different focal length for the same field-of-view. Furthermore, the curved shape of the resulting artificial compound eyes may offer space within the convexity for embedding processing units, battery, wireless communication, and inertial sensors, such as accelerometers and rate gyroscopes, which may be used for motion-related computation. Instead, in conventional cameras these components must be packed separately because the space between the convex lens and the planar image sensor must be transparent.

Preferred embodiments of the present invention will be explained in more detail with respect to the accompanying drawings, in which:
- Fig. 1: shows a high-level flow chart of a method for fabricating an imaging system according to an embodiment of the present invention;
- Fig. 2a: shows an example of a flexible substrate according to an embodiment of the present invention;
- Fig. 2b: shows a wafer comprising a plurality of microlenses according to an em- bodiment of the present invention;
- Fig. 2c: shows a wafer comprising a plurality of image sensors according to an em- bodiment of the invention;
- Fig. 3a-e: depict a method for fabricating an imaging system according to an embodi- ment of the present invention;
- Fig. 3f-k: depict a method for fabricating an imaging system according to another em- bodiment of the present invention;
- Fig. 4a: shows a top-view of an assembled imaging system before mechanically separating the optical channels according to an embodiment of the present invention;
- Fig. 4b: shows a top-view of an imaging system before mechanically separating the optical channels according to a further embodiment;
- Fig. 5a-c: show a mechanically flexible imaging systems fabricated according to embodiments of the present invention;
- Figs. 6a-c: show different wire-bonding concepts according embodiments of the pre- sent invention;
- Fig. 7a,b: show geometric dimensions of a flexible imaging system mounted to a curved substrate fabricated according to an embodiment;
- Fig. 8a-d: show perspective views of various flexible imaging systems fabricated according to different embodiments;
- Fig. 9: shows a section of a fly head compared to a bio-inspired readout architec- ture for a cylindrical imaging system fabricated according to an embodiment; and
- Fig. 10: shows a comparison of a vertebrate eye and an insect compound eye.

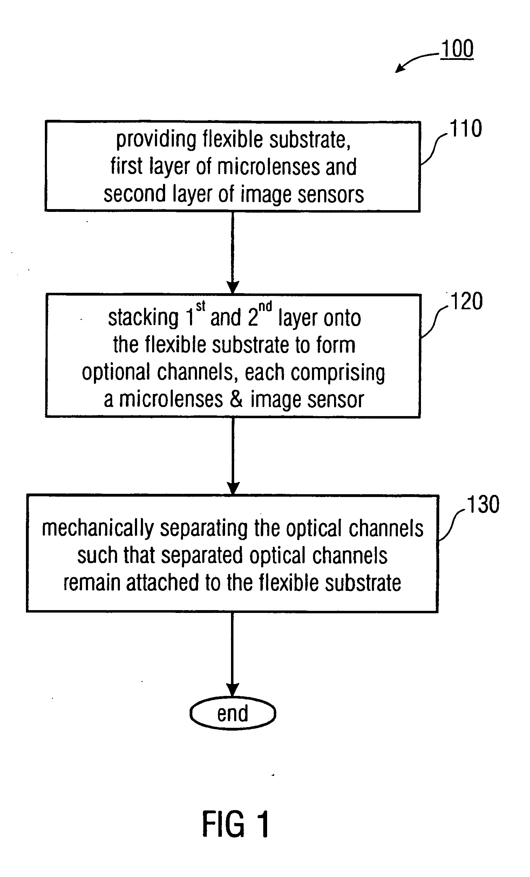

Fig. 1 shows a high-level flow chart of a method 100 for fabricating an imaging system according to an embodiment of the present invention.

In a preliminary fabrication step 110, a flexible substrate, a first layer comprising a plurality of microlenses and a second layer comprising a plurality of image sensors or photoreceptors are provided. In a following fabrication step 120 the first and the second layer are stacked onto the flexible substrate by attaching the plurality of image sensors to the flexible substrate, such that each of the plurality of microlenses and image sensors are aligned to form a plurality of optical channels (ommatidia), wherein each optical channel (ommatidium) comprises at least one microlens and at least one associated image sensor. After step 120 the optical channels are mechanically separated 130 such that the separated optical channels remain attached to the flexible substrate to form a mechanically flexible imaging system.

According to embodiments, during stacking 120 the first and the second layer onto the flexible substrate, stacking the plurality of microlenses onto the plurality of image sensors is performed before attaching the plurality of image sensors to the flexible substrate. According to embodiments the first and second layer are provided as planar layers, respectively, and stacking the first layer onto the second layer, attaching 120 the stacked first and second layer onto the flexible substrate and mechanically separating 130 the optical channels all occur in a planar state. According to different embodiments, mechanically separating 130 the optical channels may comprise cutting, sawing or etching the stacked first and second layer to physically separate neighboring optical channels.

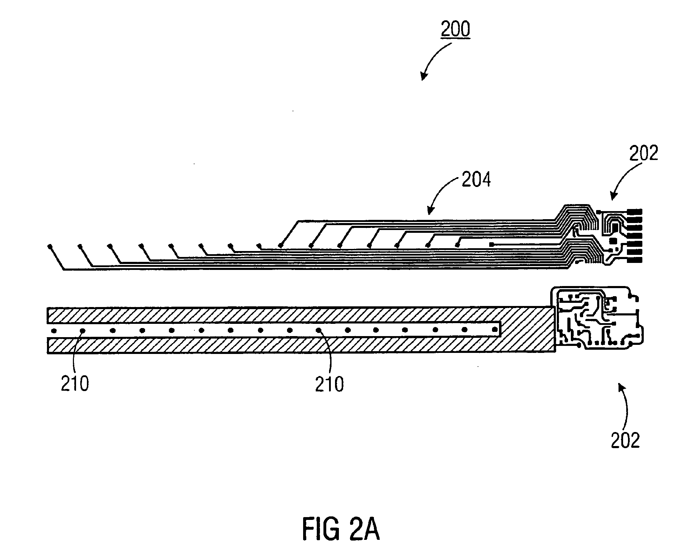

In step 110 the provided flexible substrate may be a flexible printed circuit board (e.g. a dicing tape) as ductile mechanical support for the optical channels. In case of the provision of a flexible printed circuit board, electrical connections for the plurality of image sensors to associated readout electronics via the flexible PCB are provided. "Flexible" in the present context means a capability of being bent or flexed without injury or damage. An example of a flexible substrate is shown in Fig. 2a.

The flexible substrate 200 shown in Fig. 2a is an example of a one-dimensional flexible PCB with included electronics 202. Fig. 2a (top) shows a backside of the flexible PCB 200 with wiring 204. The bottom image shows a sensing side of the flexible PCB 200 with indicated placement 210 of 16 one-dimensionally arranged image sensors. The flexible PCB 200 acts as mechanical support for the artificial ommatidia and as electrical connectivity to readout electronics. The flexible PCB 200 may be very thin, e.g. down to 100 microns, with 50-100 micron wide electrical lines 204, which may act as connective pads for a wire bonding process.

Of course, other flexible substrates may be used in other embodiments of the present invention. In case electrical interconnections are not required within the flexible substrate (which will be discussed later), the flexible substrate may also be a ductile or bendable tape, in particular a dicing tape for the (normally temporary) fixing of wafers.

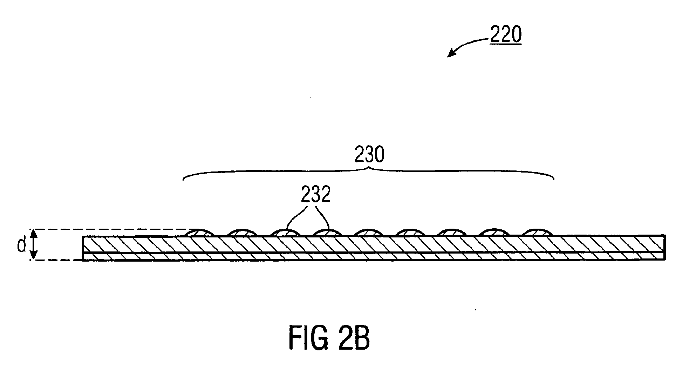

The step 110 of providing the first layer with the plurality of microlenses comprises providing a wafer 220 carrying a microlens-array 230 comprising the plurality of microlenses 232, which is exemplarily shown in Fig. 2b.

The first layer 220 carrying the plurality of microlenses 232, i.e., the compound eye optics, may be designed and/or fabricated by lithographic methods on wafer-scale to achieve a thickness d in the order of 100 microns. Parameters, such as geometry of the components, number of ommatidia per patch, optical properties of each ommatidium (field-of-view, resolution, sensitivity, overall size constraints), architecture of the underlying vision chip (photoreceptor size and layout, electrical circuitry to be built-in bonding pads), and the way the photoreceptors are electrically interconnected, may serve as input for the layout of the microlens array 230 and underlying aperture arrays (not shown) for suppression of optical channel crosstalk. Several arrangements for one or several photoreceptors per optical or visual channel are possible. The first layer 220 carrying the plurality of microlenses 232 may be a wafer comprising a glass or polymer substrate for the microlenses 232. The first layer 220 may be combined with aperture arrays and polymer spacer layers to micro-optic sandwiches of e.g. glass substrates, aperture arrays and polymer spacer layers.

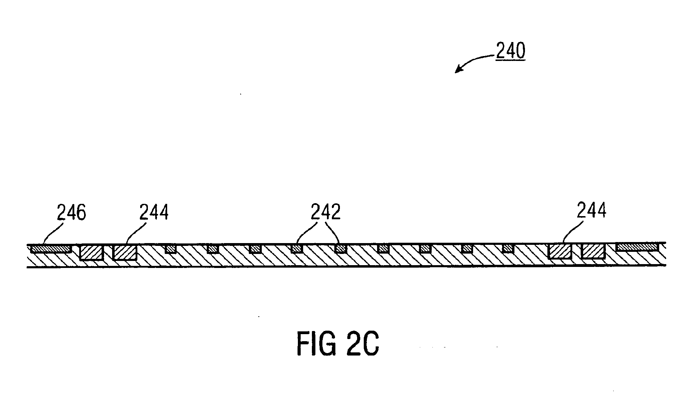

Fig. 2c shows a schematic side-view of the second layer 240 comprising the plurality of image sensors or photoreceptors 242. The second layer 240 may be fitted underneath the first layer 220 carrying the microlens array 230. However, vision chips comprising the image sensors 242 cannot be conventional imagers for several reasons. First, they need to provide space around each photoreceptor 242 for the separation step 130 that will occur once the first layer 220 carrying the microlens array 230 has been bonded, e.g. by gluing, on top of the image sensor wafer 240. The fact that each photoreceptor 242 may be singulated also means that each of them may need connecting pads for wire bonding to the underlying flexible substrate 200 or directly to neighboring optical channels. In addition, passive circuitry 244, e.g. front end electronics like a read-out electronic, may be added next to each photoreceptor 242. External bond pads 246 serve for connecting the second layer 240, i.e. the optoelectronic photoreceptors 242, to further (e.g. back end) read-out circuitry (not shown). The image sensor chips may extend beyond at least a part of the periphery of the optic to allow access to the bond pads on the image censor chip also after having applied the optic to the image sensor chip.

According to an embodiment, a VLSI technology may be used to provide very low-power image sensor circuits by relying on sub-threshold methods (see Liu, S., Kramer, J., Indiveri, G., Delbrück, T., and Douglas, R. (2003) Analog VLSI: Circuits and Principles. MIT Press, Cambridge, MA). Examples of additional functionalities include the enhancement of the dynamic range by using a self-adaptive circuit (see Delbrück, T., Mead, C. (1995) Analog VLSI phototransduction by continuous-time, adaptive, logarithmic photoreceptor circuits. IEEE Computer Society Press, pp. 139-161) that offers a huge range of operation in terms of light intensity: they can operate in any light condition ranging from moonlight to full sun (1 lux to 105 lux) without any external tuning while consuming very little power (typically in the order of 50 µW). Such an adaptive photoreceptor 242 is interesting not only for DC operation, but also for AC operations because it is designed in such a way that a sudden change in light level is transformed into an impulse that gets back to the initial resting level with a time constant that depends on the light change amplitude.

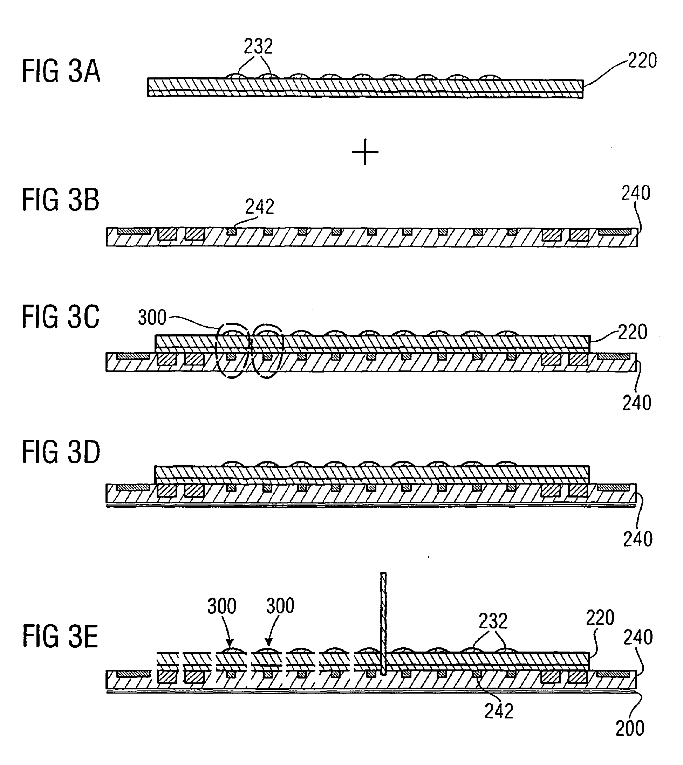

Now that components for fabricating the mechanically flexible imaging system, i.e., the flexible substrate 200, the first layer 220 of microlenses and second layer 240 of image sensors, have been explained, Figs. 3a-e show a method for fabricating the flexible imaging system according to an embodiment of the present invention. As can be seen, when stacking the first and the second layers 220, 240 shown in Figs. 3a and 3b onto the mechanically flexible substrate 200 (see Fig. 3c), a stacking of the plurality of microlenses 220 onto the plurality of image sensors 240 is performed before attaching the second layer 240 comprising the plurality of image sensors 242 to the flexible substrate 200 (see Fig. 3d). The first and the second layers 220, 240 are stacked onto each other such that each of the plurality of microlenses 232 and image sensors 242 are aligned to form a plurality of optical channels 300, wherein each optical channel 300 comprises at least one microlens 232 and at least one associated image sensor 242. In order to obtain a mechanically flexible imaging system the optical channels 300 are mechanically separated (see Fig. 3e), such that the separated optical channels 300 remain attached to the flexible substrate 200. The mechanical separation of the optical channels 300 may comprise cutting, sawing, etching, dicing, or laser dicing the stacked first and second layers 220, 240 to physically separate neighboring optical channels 300. As it can be seen, the flexible substrate 200 is not cut or mechanically separated, because it acts as mechanical support for the optical channels 300.

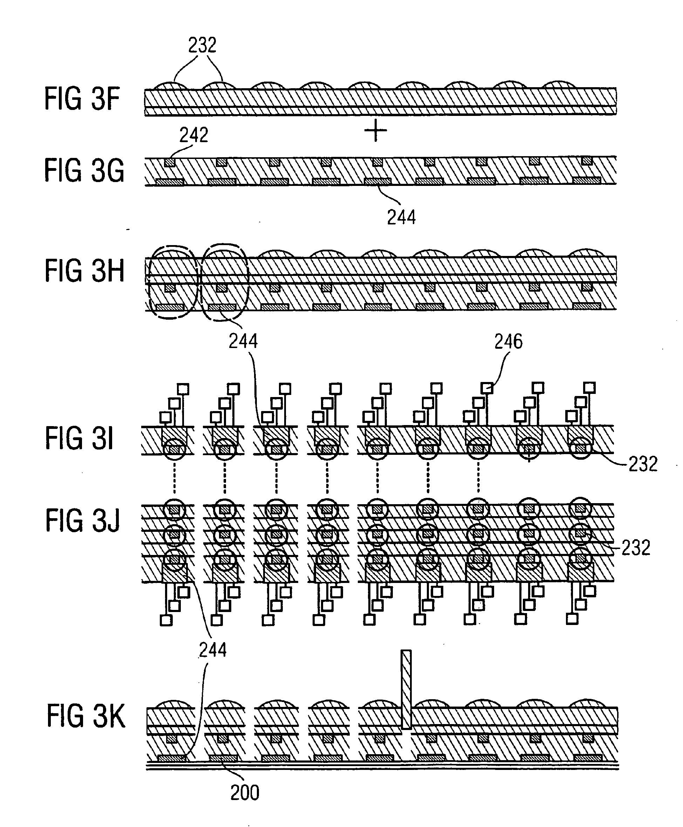

Figs. 3f-k show a method for fabricating the flexible imaging system according to another embodiment of the present invention. The first and the second layers 220, 240 shown in Figs. 3f and 3g correspond substantially to those of Figs. 3a and 3b, except that in the image sensor layer 240 the front end electronics (e.g. read-out electronics) are integrated such that each image sensor has associated therewith a front-end electronic circuit 244. The first and the second layers 220, 240 shown in Figs. 3f and 3g are combined (see Fig. 3h) and attached onto the mechanically flexible substrate 200. While Figs. 3f-h show side views of the first and the second layers 220, 240, Figs. 3i-j show top views of the separated layers. Fig. 3i shows the arrangement of a single image sensor 242 per column while Fig. 3j shows an embodiment comprising a plurality of image sensors 242 per column. As can be seen from Figs. 3i-j, the front-end electronics 242 are arranged at the extremity of the layer and the pads 246 are arranged in the respective column, i.e. along a direction perpendicular to the bending direction. Fig. 3k is again a side view showing the mechanically flexible imaging system having the optical channels 300 which are mechanically separated in a manner as described above.

Thus, in the embodiment described with reference to Figs. 3f-k, the front-end electronics and the bond pads are integrated and placed at the extremity of each column, so that other than in the embodiments shown in Figs. 2c and 3a-e there is no need to arrange the read-out electronics and pads at the periphery of the layer 240. In this embodiment the read-out electronics and pads are simply integrated and arranged at the tip of each photosensor array or each column of ommatidia. There is no need to place the electronics at a back side but just near the pixels of each columns' extremity. This arrangement is advantageous as it avoids the wire-bonding between each column so that bending the flexible substrate will not damage the wire connections.

According to embodiments, a precise combination of microlens- and photoreceptor arrays onto the mechanically flexible substrate 200 including electrical wiring and encapsulation may be achieved due to the fact that all assembly steps occur in a planar state, which allows high precision, while the final optical channel or ommatidia patch will be completely mechanically flexible. I.e., providing the first and second layer 220, 240 comprises providing planar layers, respectively, wherein stacking the first layer 220 onto the second layer 240, attaching the stacked first and second layer onto the flexible substrate 200) and mechanically separating the optical channels 300 occur in a planar state. To achieve the alignment of the optical dies (first layer 220) with the photoreceptor dies (second layer 240) a matching of alignment marks in both structures may be used. Through special chip bonding a sub-micron precise lateral and rotational alignment of the image sensors 242 with respect to their corresponding microlenses 232 is possible. During chip bonding extremely short focal lengths of the microlenses 232 has to be dealt with. An axial or vertical distance between the optics layer 220 and the image sensors 242 of the ommatidia 300 could be determined by the amount and viscosity of an applied UV-glue and/or by active setting via manipulation stages. The optical channels 300 or columns thereof may be singulated from each other by wafer dicing only once the interconnection between the lenslets 232 and the vision chip 240 is permanently fixed and the lens-vision-chip-sandwich has been applied to the flexible PCB 200, which at the same time serves as a dicing tape. The electrical connection from the image sensors 242 to the flexible PCB 200 or directly between the optical channels or ommatidia 300 themselves may be achieved by wire bonding.

The optical channels or ommatidia 300 are the building blocks of curved compound eyes. Just like in nature, the proposed mechanically flexible ommatidia 300 will have to display the same structure across the entire surface of the compound eye, no matter what shape and curvature the eye takes. According to embodiments of the present invention a density of optical channels or ommatidia 300 is 2 - 10 ommatidia per mm². As has been explained before, the ommatidia 300 are made of a first layer 220 of custom made microlenses 232 aligned on top of a second layer 240 of a custom-made aVLSI vision chip and further bonded to a flexible PCB 200. The first two layers 220 and 240 of the obtained sandwich are then diced in order to mechanically separate the visual channels 300 (ommatidia singulation) and to enable the bending of the mechanically flexible substrate 200.

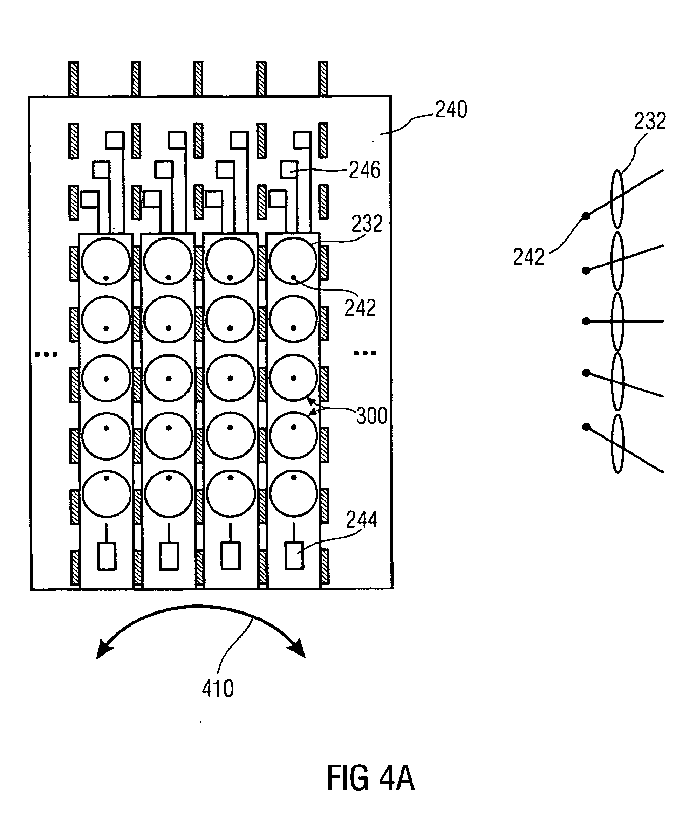

A schematic top-view of the obtained mechanically flexible imaging system is given in Fig. 4a.

It can be seen, that the top layers 220, 240 are diced, as indicated by the dashed vertical lines, in order to mechanically separate neighboring rows or columns of optical channels 300. Thereby the sensor 240 is not affected by the separation process. The microlenses 232 may be chirped for correction of off-axis aberrations. In order to obtain a small vision field when bending the flexible imaging system cylindrically, the microlenses 232 and the image sensors 242 may be displaced, like schematically shown in Fig. 4a, right. Here, displaced means that the microlenses 232 and their associated image sensors 242 do not lie on a common vertical axis. After the column-wise separation of the optical channels 300, the sensor 240 may be mounted to a bent surface, for example, a cylindrical surface, as indicated by the arrow 410 in Fig. 4a.

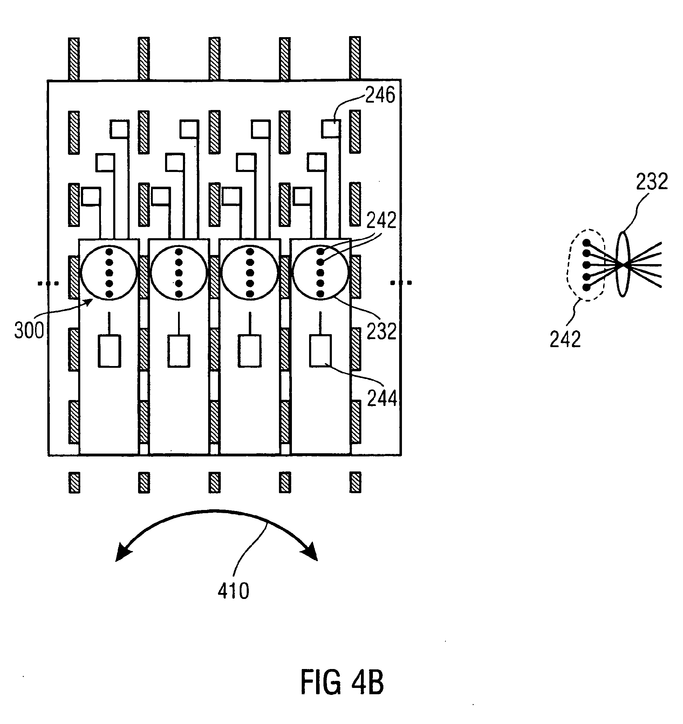

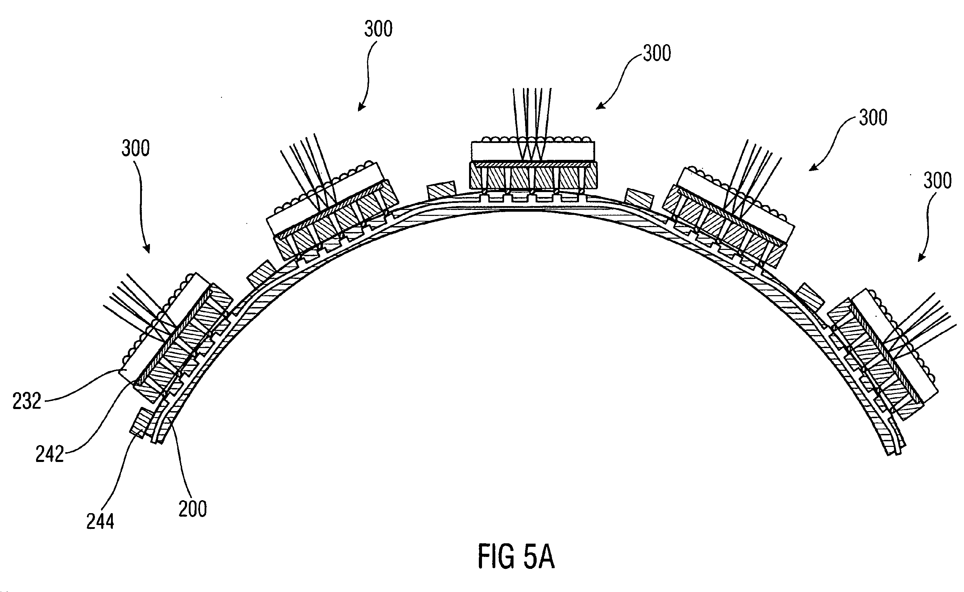

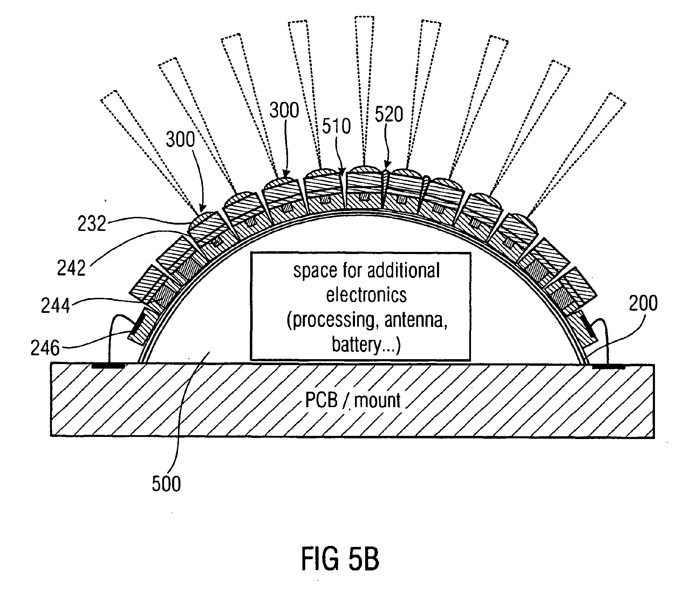

As is schematically shown in Fig. 4b, also a plurality of image sensors 242 may be associated to a single microlens 232, such that an optical channel 300 comprising the microlens 232 and the plurality of image sensors 242 serves for getting a column image perpendicular to the curved spreading of the optical-channel-columns. The curved or cylindrical spreading of the flexible imaging system is shown in Figs. 5a, b.

Optical viewing directions of the individual separated optical channels 300 are tunable according to a radius of curvature of a supporting structure (not shown in Fig. 5a). This allows to obtain a desired ratio between viewing angle and field-of-view of the individual optical channels 300, repeatable across the whole compound eye.

Fig. 5b shows a side-view of a flexible imaging system comprising mechanically separated optical channels 300 attached to the flexible substrate 200, wherein the flexible substrate 200 is glued to a semi-cylindrical curved basis 500. The curved convex basis 500 thereby provides enough space for additional electronics, e.g., optic flow processing units (FPGA or DSP), antenna or battery circuits.

Due to the physical separation of the optical channels 300 on the PCB 200, there are cavities or grooves 510 between separated optical channels 300. Screening of the ommatidia or optical channel side-walls with opaque curable material in order to prevent optical crosstalk between neighboring ommatidia or optical channels 300 is possible. The screening and encapsulation with opaque curable could also serve as stabilization and encapsulating for a curved arrangement of the ommatidia. Hence, according to embodiments, the cavities 510 between the separated optical channels 300 may be filled with a sealing compound material 520. The sealing compound material 520 may be a optically isolating sealing compound material for isolating neighboring optical channels 300. After filling the sealing compound material 520 into the cavities 510, the flexible substrate 200 carrying the separated optical channels 300 may also be removed from the curved basis 500. Due to the filled cavities 510 the curved shape of the imaging system will remain even after removing it from the curved basis 500.

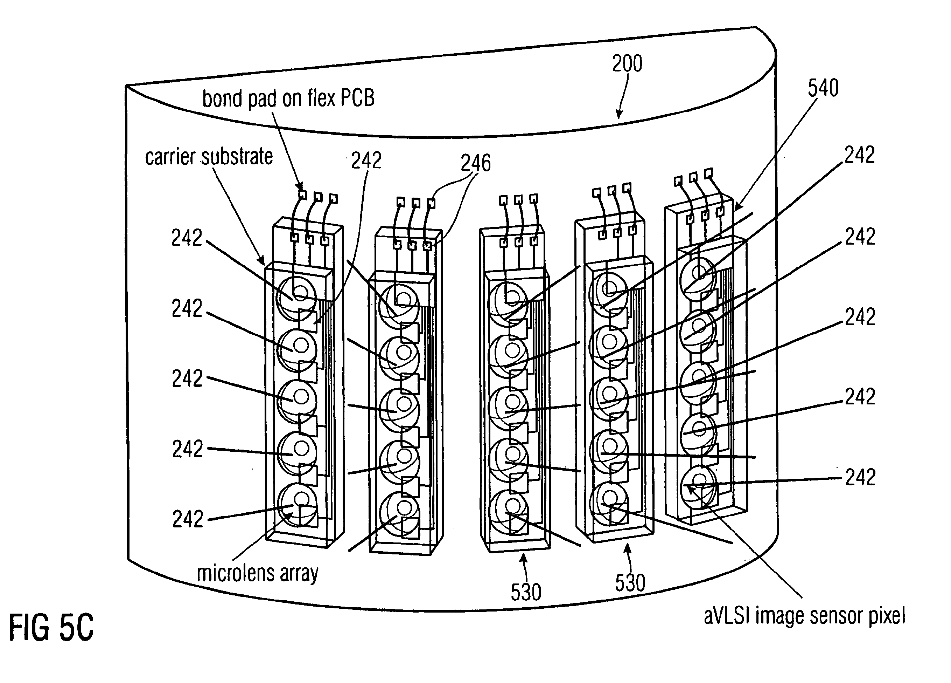

Fig. 5c shows a perspective view of a semi-cylindrical curved compound eye imaging system having separate rows or columns 530 of optical channels 300. Each optical channel comprises a microlens 232 and at least one image sensor 242 on a image sensor die 540, the image sensor die 540 bonded to a flexible PCB 200 by bond wires and bond pads 246.

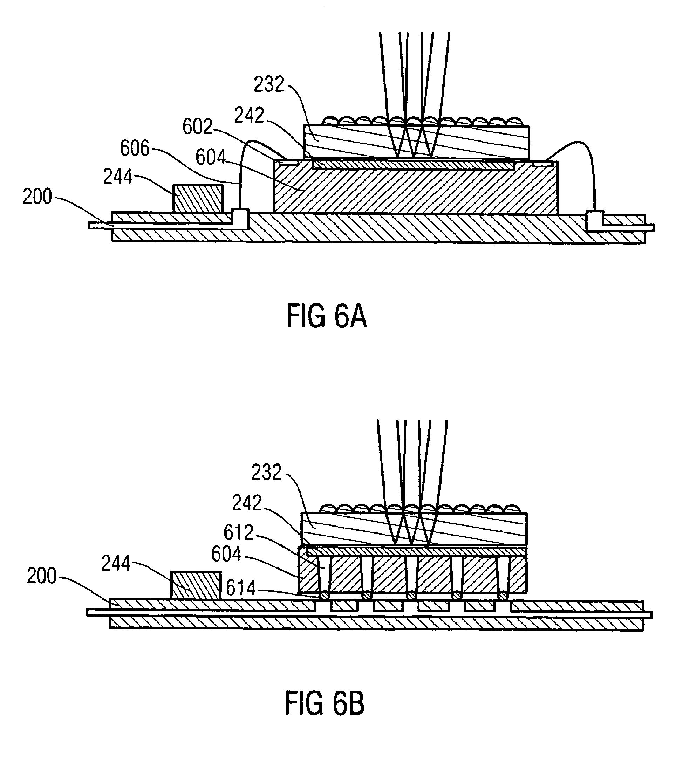

Different wire-bonding schemes will now be explained with reference to Figs. 6a, 6b.

Fig. 6a shows an example of front side wire-bonding an optical channel 300 to the flexible substrate or PCB 200. Contact pads 602 of an image sensor die 604 are connected to the flexible PCB 200 by bond-wires 606. Further, passive electronics 244 associated to the image sensor 242, such as, e.g., column amplifiers, may be foreseen on the flexible PCB 200.

Fig. 6b shows an example of wire-bonding an optical channel 300 to the flexible substrate or PCB 200 with TSV (through silicon via). The image sensor 242 (or image sensor array) is connected to the flexible PCB 200 by means of through-hole silicon vias 612 and solder bumps 614. Thereby, the electrical connections 612 may be provided by correspondingly etching the substrate (e.g. silicon) of the image sensor die 604.

In both examples according to Fig. 6a, b electrical connections provided by means of the flexible substrate 200 may be realized e.g. by printing contact bands and/or electrical connections on the flexible substrate 200 e.g. with printable conductive ink.

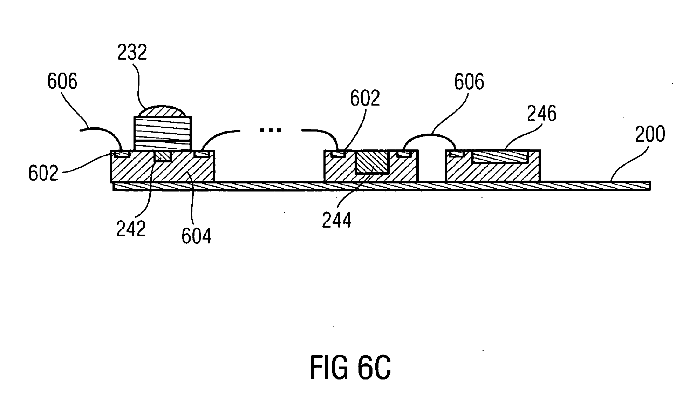

A further alternative for connecting the image sensors with their periphery is shown in Fig. 6c. Here, pixels or image sensors 242 are connected with their respective periphery 244 and external bond pads 620 by bonding wires 606 between individual silicon pieces. There is no down-routing to the flexible substrate 200 and, hence, in this case the flexible substrate 200 does not need to have electrical connection properties.

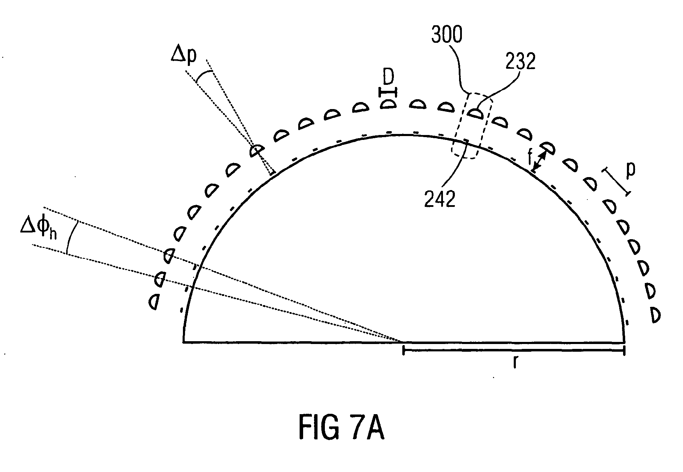

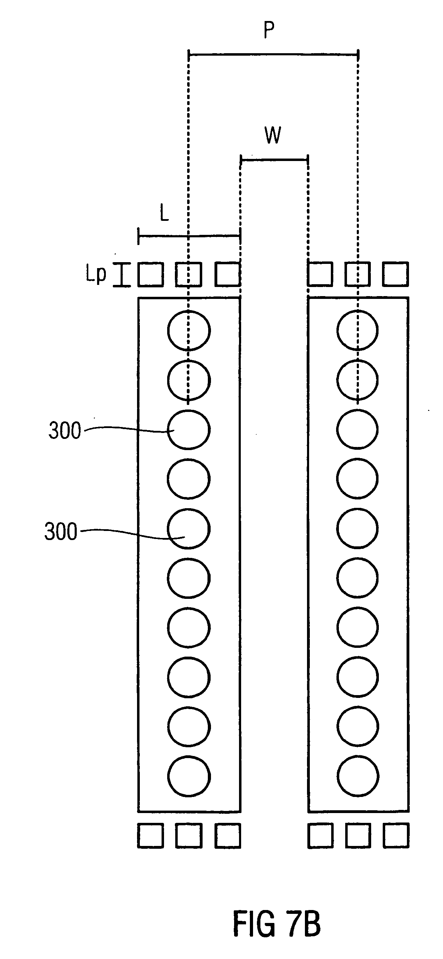

After having explained embodiments of the fabrication method and the flexible imaging system itself, a design example of the flexible imaging system is now given referring to Figs. 7a, b.

A semi-cylindrical curved surface or basis 500 with radius r = 5 mm may be considered. The resulting arc length is 1 = π r ≈ 15 mm (half a cylinder). Microlenses 232 with a diameter D = 150 µm and a focal length of f = 400 µm may be used. An angular horizontal spacing Δφₕ may be 6°. Resulting therefrom are 180°/6° = 30 lenses to cover the entire semi-cylinder 500. In this case an acceptance angle Δρ of also 6 ° is needed. A pixel or image sensor 242 of 40 µm x 40 µm and a focal length of about 400 µm may be used. The interval (free space) between each lens 232 will be (15 - 30*0.15)/ 30 = 350 µm. Thus, the pitch p will be 350 µm + 150 µm = 500 µm. This pitch value should be large enough to let the resulting optical channel 300 be diced without any damage. A vertical interommatidial angel Δφᵥ may be equal to Δφₕ for a field-of-view of 60°. The main limit lies in the ability to shift the visual axis. This means that each column of the imaging system will be composed of ten optical channels 300 (ommatidia), like shown in Fig. 7b. Even if such a imaging system or compound eye may have a rather coarse resolution, it is well suited and dedicated to optic flow measurement. In any case, it can be considered as a classical imager yielding an image that can be useful for the human eye.

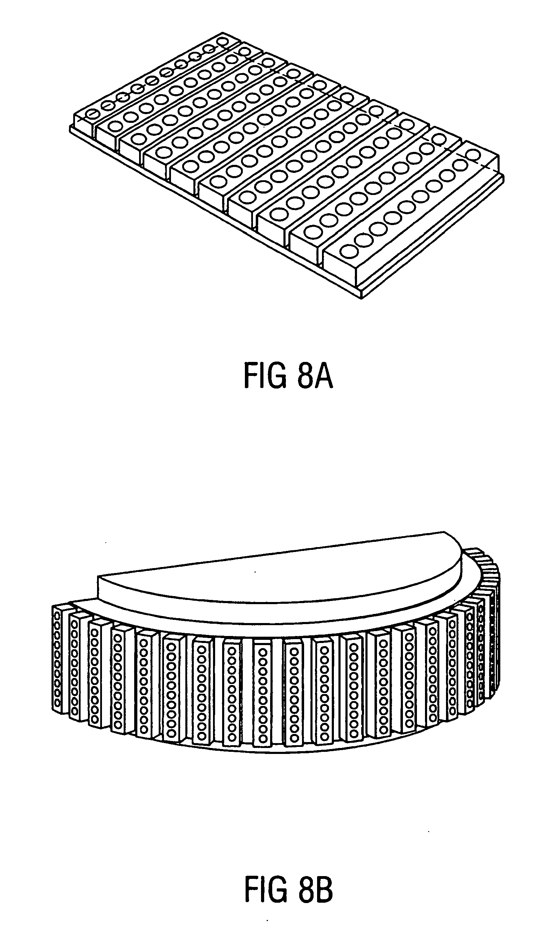

Flexible imaging systems may be the building blocks for a realization of fully functional curved compound eyes. After the singulation of the ommatidia 300, or patches of them (see Fig. 8a), on a flexible PCB, which at the same time serves a dicing tape, the optical viewing directions are tuneable according to the radius r of curvature of a supporting structure 500. This will allow to obtain a desired ratio between viewing angle and field-of-view of the individual ommatidia, repeatable across the whole compound eye.

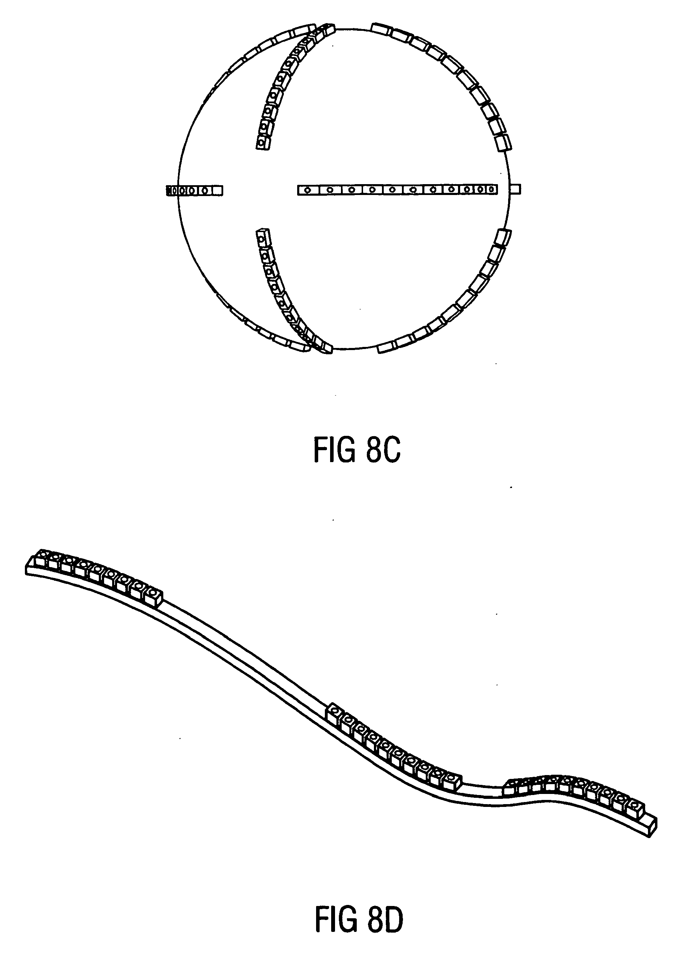

With embodiments of the present invention, fabrication of various types of curved compound eyes is possible, e.g., cylindrical compound eyes (see Fig. 8b), active or actuated compound eyes wherein a cylindrical compound eye is endowed with scanning movements, spherical eyes (see Fig. 8c) and tape-like compound eyes (see Fig. 8d).

The cylindrical compound eye shown in Fig. 8b may offer a very large field-of-view in the horizontal plane (up to 360°). The vertical columns of ommatidia - when not diced - may be designed to display a slight difference in pitch between the photoreceptor and microlenses (see Fig. 4a, right), such that the vertical field-of-view could span up to 60°, even without adding vertical curvature. The cavity of a cylindrical compound eye may offer space for encasing processing units and small actuators. A great advantage may be seen in the free space for components in the eye cavity, which may result in very compact and self-sufficient sensing devices. In the imaging system according to Fig. 8b, the plurality of optical channels 300 is overall arranged in a two-dimensional array of optical channels, wherein neighbouring rows 530 of optical channels are mechanically separated.

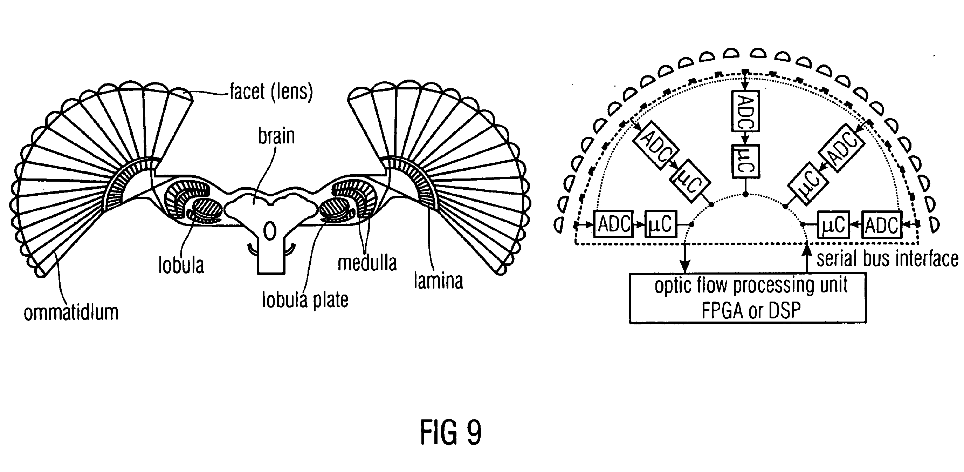

The columnar arrangement of ommatidia 300 seems to be the easiest way of providing a 2D field of view using only 1D flexibility at the level of the substrate 200. Since a detection of fast motion-related events shall be detected, bio-inspired electronic architectures (Fig. 9, right) featuring distributed analog-to-digital converters (ADC) and programmable processing units may be used. This may enable fast visual signal acquisition and local processing before sending the information further to a central processor for global visual processing. For instance, a micro-controller may be integrated at the column level to process locally the optic flow. In the case where a column is composed of more than 1 pixel (2D retina), a local microcontroller could process the optic flow measured by each vertical ommatidia. In any case, a programmable processing unit (microcontroller or FPGA) may be added to process all the incoming signals and compute global information.

The active, or actuated compound eye may be seen as an cylindrical eye augmented with a device providing a very small minimum visibile (i.e., the smallest area distinctly perceivable by the eye) and an outstanding hyper acuity (Viollet and Franceschini 2001, Viollet and Franceschini 2005). These two properties, rarely encountered in any artificial visual sensor, will rely on the ability of the physical sensor to generate controlled vibrations. In the context of actuator technology for micro-actuation systems, at least two technologies may be considered: piezo and artificial muscles, or shape memory alloy (SMA). Piezoelectric actuators are widely used due to their high speed, high resolution, good mechanical durability, high output force and low power consumption (Tao et al., 2007). For example, piezo bender actuators have been widely used in academic studies and industrial applications, e.g., as piezoelectric switch, valve, pump, ultrasonic motor, printer head, piezoelectric fan, piezoelectric tube scanner and quick focusing lenses (e.g, Yoo et al., 2000). The success of piezo technology relies on its high bandwidth (e.g, about 500 Hz). This means that piezo actuators can be controlled in open loop, leading to a drastic simplification of the control electronics. However, the necessary high voltage electronics required for actuating piezo actuators is often complex and bulky. These requirements also limit the use of pie-zoactuators in autonomous micro-robots (Stelz et al., 2006). However, novel architectures based on boost converter technology open ways to overcome the limitations imposed by the bulky size of power piezo driver. Even if piezo technology plays a major role in micro-actuating, recent developments in shape memory alloys may lead to SMA actuators for implementing the micro-scanning of the imaging system. E.g., Biometal fiber developed by Toki Inc. are currently used in a smart 0.8 g servo actuator including a very small electronic driver. This kind of actuators is now used in many research fields.

A possible realization of a spherical compound eye (Fig. 8c) consists of arranging several ommatidia patches around a sphere, thus enabling a truly omnidirectional field of view and providing extra free space in the eye cavity for additional components, such as accelerometers and rate gyros, which are necessary for some types of motion-related analysis. For example, the rotational component of optic flow, which does not correlate with distance to surrounding objects, can be discounted if the rotational components of the eyes are available from 3-axis rate gyroscopes (Rodriguez, A., Andersen, E., Bradley, J. and Taylor, C. (2007) Wind Estimation Using an Optical Flow Sensor on a Miniature Air Vehicle. AIAA Conference on Guidance, Navigation, and Control; Zufferey, J.-C. and Floreano, D. (2006) Fly-inspired Visual Steering of an Ultralight Indoor Aircraft. IEEE Transactions on Robotics, 22(1) pp. 137-146; Zufferey, J.-C., Beyeler, A. and Floreano, D. (2009) Optic Flow to Steer and Avoid Collisions in 3D. In Flying Insects and Robots, Berlin : Springer-Verlag. In press).

A lightweight artificial spherical compound eye can cover a truly omnidirectional field of view in order to emulate the visual capabilities of insects. Among various possibilities, a series of circular PCBs may be used or several lines of ommatidia may be arranged directly onto a spherical surface (Fig. 8c). The former option may facilitate the interconnection of the ommatidia, whereas the latter could be easier to integrate onto the surface of a vehicle or a robot. Since it is well known that the inertial sense is of high importance to interpret visual information such as optic flow, the free space available within the spherical compound eye may be exploited to add a set of inertial sensors: 3-axes gyroscopes and 3-axes accelerometers.

Tapes of elongated and flexible compound eyes (Fig. 8d) may consist of bendable printed circuits embroiled with multiple ommatidia, to be attached to various surfaces or sewed into clothes. In the imaging system according to Fig. 8d, the plurality of optical channels 300 is arranged in a one-dimensional array of optical channels, wherein neighbouring optical channels are mechanically separated. Adding other components may also be considered, such as wireless modules and batteries, which could be soldered on the tape, for making it energetically self-sufficient and capable of communicating motion-related information to other devices. The viewing directions of the ommatidia is determined by the underlying surface and not fixed at fabrication time.

Elongated vision-tapes can be attached onto various flat and curved surfaces or sewed into clothes in order to perceive motion-related information in divergent directions. Unlike standard cameras, which occupy a volume because of their single lens architecture, this vision-tape may cover a significantly wider surface of several centimeters while being only a few micrometers thick. This skin-like property may allow covering widely divergent viewing directions (depending on the underlying surface) while remaining almost unnoticeable from a mechanical point of view. An interesting aspect with this special type of imaging system is that we cannot assume a priori knowledge of the repartition of the viewing directions of the ommatidia since the support on which the tape will be glued could be of any shape or even moving and flexing while the compound eye is operational (e.g., when sewn into clothes).

Two approaches may be considered to actually produce such tapes. The first one would consist of replicating patches of ommatidia produced according to embodiments of the present invention and solder them on top of a second flexible PCB of larger size. The second approach would be to pick and place each single ommatidium from its production substrate onto the longer flexible PCB. The first approach is simpler in terms of assembly procedure, but the tape may end up not being homogeneously populated with ommatidia and the thickness may be greater due to the superposition of two layers of flex PCB in some places. The second approach instead may involve dissolving the glue that has been used in the ommatidia production process (once they have been diced apart from each other), carefully pick them one by one and gluing them onto the larger PCB before they can be wire-bonded and encapsulated. Although time consuming, this latter approach could allow more freedom in the way the ommatidia can be spread across the tape, which would represent an advantage. A final form of the vision-tape should include thin batteries and a means of sending out motion-related information via wired or wireless communication.

Another important aspect of fully functional compound eyes is the design of the readout circuitry and built-in micro-processing units. Taking inspiration from the fly's visual system (Fig. 9, left), which is composed of a series of neuropils responsible for successive visual processing tasks (local pre-processing -> local motion detection -> global interpretation of motion fields), the use of a network of interconnected microcontrollers (Fig. 9, right) may be considered that may be directly soldered onto the flexible substrate of the ommatidia patches. Similarly to the lamina and medulla in the fly brain, the local micro-controllers can be used to pre-process local visual information in order to remove noise, adapt gains, and estimate optic flow among adjacent ommatidia. Similarly to the lobula in the brain of the fly, a main processing unit could then integrate the local information processed by the distributed microcontrollers into higher level signals such as global optic-flow fields, distance estimates or ego-motion. All the processing units (e.g. low-power micro-controllers or FPGA) may be fully programmable.

To summarize, embodiments of the present invention provided a method of fabricating a compound eye imaging system which may be applied to a curved basis with a highly-precise relation between microlenses and photoreceptors which leads to a highly precisely determined sampling angle. Microlenses and photoreceptors make up optical channels, wherein a flexible substrate serves as a mechanical connection between neighboring optical channels. Additionally, an opaque sealing compound may be used for optical channel separation.

According to embodiments the optics comprising the microlenses as well as the image sensors are provided in planar stacking technique. Both layers are combined in planar condition by waferscale or chipscale mounting. Mounting the microlens-layer and the image-sensor-layer in the planar domain and using established methods allows for a highly precise relation between microlenses and photoreceptors in the sub-micron area. The bonded components are then attached to the flexible substrate which may, at the same time, serve as a dicing tape. In a next step, the optical channels resulting from microlenses and associated image-sensors are singulated by, e.g., sewing the microlens-photosensor-sandwich, however, without "injuring" the flexible substrate. The resulting imaging system gets flexible or bendable, whereas the association microlens-photosensor within the optical channels remains fixed. The singulation may be performed via sawing, laser-cutting, etching, etc. The obtained flexible imaging device may be bent and/or mounted to a curved basis. Cavities between the separated optical channels may be filled with a hardening sealing compound material, which may be preferably a black material for optically isolating the optical channels. The flexible imaging device may be fixed to the curved basis permanently, or may be again separated from it after "freezing" the curvature. Alternatively, a completely flexible or actuated form may be envisaged, like it has been explained above. In this case however, the current deformation condition has to be known in order to recognize an object from the image.

Although several aspects of the present invention have been described with respect to an imaging system it is to be understood that those aspects also serve as a description of a related method for fabricating the imaging system, such that a block or an element of the imaging system may also interpreted as a related step or a feature of a step of the method for fabricating. Also, aspects that have been described in connection with or as a step of a method may also be interpreted as a description of a respective block, or a detail, or a feature of a respective imaging system.

Embodiments of the invention described that the image sensors are connected to the flexible substrate by wire-bonding. The invention is not limited to such a technique, rather other techniques for connecting the image sensors to the flexible substrate may be used, e.g. by trough silicon interconnection (TS-VIAS), gold bands, printed conductive traces, conductive ink. Also other know techniques may be used.

## Claims

1. A method (100) for fabricating a mechanically flexible imaging system, the method comprising:
providing (110) a flexible substrate (200);
providing (110) a first layer (220) comprising a plurality of microlenses (232);
providing (110) a second layer (240) comprising a plurality of image sensors (242);
stacking (120) the first and the second layer (220; 240) onto the flexible substrate (200) such that each of the plurality of microlenses (232) and image sensors (242) are aligned to form a plurality of optical channels (300), each optical channel comprising at least one microlens and at least one associated image sensor, wherein the first and the second layer (220; 240) are attached onto the flexible substrate (200) such that the second layer (240) comprising the plurality of image sensors (242) is attached to the flexible substrate; and
mechanically separating (130) the optical channels (300) such that the separated optical channels remain attached to the flexible substrate (200) to form a mechanically flexible imaging system.

2. The method according to claim 1, wherein providing the flexible substrate (200) comprises providing a flexible printed circuit board as mechanical support for the optical channels (300).

3. The method according to claim 2, wherein providing the flexible printed circuit board (200) comprises providing electrical connection from the plurality of image sensors (242) to associated readout electronics via the flexible printed circuit board.

4. The method according to one of the preceding claims, wherein the plurality of image sensors (242) are provided using an analogue very large scale integration technology.

5. The method according to one of the preceding claims, wherein providing the plurality of image sensors (242) comprises providing connection pads (246) for bonding each of the plurality of image sensors to the flexible substrate.

6. The method according to one of the preceding claims, wherein, during stacking the first and the second layer onto the flexible substrate, stacking the plurality of microlenses onto the plurality of image sensors is performed before attaching the plurality of image sensors to the flexible substrate.

7. The method according to one of the preceding claims, wherein providing the first and second layer (220; 240) comprises providing planar layers, respectively, and wherein stacking the first layer (220) onto the second layer (240), attaching the stacked first and second layer onto the flexible substrate (200) and mechanically separating the optical channels (300) occur in a planar state.

8. The method according to one of the preceding claims, wherein mechanically separating the optical channels (300) comprises cutting, sawing, etching, dicing, or laser dicing the stacked first and second layer to physically separate neighbouring optical channels (300).

9. The method according to one of the preceding claims, wherein stacking the plurality of microlenses (232) onto the plurality of image sensors (242) comprises matching previously provided alignment marks on the first and/or second layer allowing an exact alignment of microlenses with associated image sensors.

10. The method according to one of the preceding claims, wherein stacking the plurality of microlenses (232) onto the plurality of image sensors (242) comprises gluing the first layer (220) onto the second layer (240).

11. The method according to one of the preceding claims, wherein attaching the plurality of image sensors (242) to the flexible substrate (200) comprises bonding of electrical connections of the image sensors with electrical connections of the flexible substrate.

12. The method according to one of the preceding claims, wherein the method further comprises, after stacking the plurality of microlenses (232) onto the plurality of image sensors (242) and attaching the plurality of image sensors to the flexible substrate (200), mounting the flexible substrate carrying the separated optical channels (300) to a curved surface (500).

13. The method according to claim 12, wherein, after mounting the flexible substrate (200) to the curved surface (500), cavities (510) between the separated optical channels (300) are filled with a sealing compound material (520).

## Patentansprüche

1. Ein Verfahren (100) zum Herstellen eines mechanisch flexiblen Bilderzeugungssystems, wobei das Verfahren folgende Schritte aufweist:
Bereitstellen (110) eines flexiblen Substrats (200);
Bereitstellen (110) einer ersten Schicht (220), die eine Mehrzahl von Mikrolinsen (232) aufweist;
Bereitstellen (110) einer zweiten Schicht (240), die eine Mehrzahl von Bildsensoren (242) aufweist;
Stapeln (120) der ersten und der zweiten Schicht (220; 240) auf das flexible Substrat (200), so dass jede/r der Mehrzahl von Mikrolinsen (232) und Bildsensoren (242) ausgerichtet ist, um eine Mehrzahl von optischen Kanälen (300) zu bilden, wobei jeder optische Kanal zumindest eine Mikrolinse und zumindest einen zugeordneten Bildsensor aufweist, wobei die erste und die zweite Schicht (220; 240) auf dem flexiblen Substrat (200) befestigt sind, so dass die zweite Schicht (240), die die Mehrzahl von Bildsensoren (242) aufweist, an dem flexiblen Substrat befestigt ist; und
mechanisches Trennen (130) der optischen Kanäle (300), so dass die getrennten optischen Kanäle an dem flexiblen Substrat (200) befestigt bleiben, um ein mechanisch flexibles Bilderzeugungssystem zu bilden.

2. Das Verfahren gemäß Anspruch 1, bei dem das Bereitstellen des flexiblen Substrats (200) das Bereitstellen einer flexiblen gedruckten Schaltungsplatine als mechanische Stütze für die optischen Kanäle (300) aufweist.

3. Das Verfahren gemäß Anspruch 2, bei dem das Bereitstellen der flexiblen gedruckten Schaltungsplatine (200) ein Bereitstellen einer elektrischen Verbindung von der Mehrzahl von Bildsensoren (242) zu einer zugeordneten Ausleseelektronik über die flexible gedruckte Schaltungsplatine aufweist.

4. Das Verfahren gemäß einem der vorhergehenden Ansprüche, bei dem die Mehrzahl von Bildsensoren (242) unter Verwendung einer analogen Höchstintegrationstechnologie bereitgestellt wird.

5. Das Verfahren gemäß einem der vorhergehenden Ansprüche, bei dem das Bereitstellen der Mehrzahl von Bildsensoren (242) ein Bereitstellen von Verbindungsanschlussflächen (246) aufweist zum Verbinden von jedem der Mehrzahl von Bildsensoren mit dem flexiblen Substrat.

6. Das Verfahren gemäß einem der vorhergehenden Ansprüche, bei dem während des Stapelns der ersten und der zweiten Schicht auf das flexible Substrat ein Stapeln der Mehrzahl von Mikrolinsen auf die Mehrzahl von Bildsensoren durchgeführt wird, bevor die Mehrzahl von Bildsensoren an dem flexiblen Substrat befestigt wird.

7. Das Verfahren gemäß einem der vorhergehenden Ansprüche, bei dem das Bereitstellen der ersten und der zweiten Schicht (220; 240) jeweils ein Bereitstellen von planaren Schichten aufweist, und bei dem das Stapeln der ersten Schicht (220) auf die zweite Schicht (240), das Befestigen der gestapelten ersten und zweiten Schicht auf dem flexiblen Substrat (200) und das mechanische Trennen der optischen Kanäle (300) in einem planaren Zustand auftreten.

8. Das Verfahren gemäß einem der vorhergehenden Ansprüche, bei dem das mechanische Trennen der optischen Kanäle (300) Schneiden, Sägen, Ätzen, Vereinzeln oder Laser-Vereinzeln der gestapelten ersten und zweiten Schicht aufweist, um benachbarte optische Kanäle (300) physikalisch zu trennen.

9. Das Verfahren gemäß einem der vorhergehenden Ansprüche, bei dem das Stapeln der Mehrzahl von Mikrolinsen (232) auf die Mehrzahl von Bildsensoren (242) ein Übereinstimmen von vorher bereitgestellten Ausrichtungsmarkierungen auf der ersten und/oder zweiten Schicht aufweist, was eine genaue Ausrichtung von Mikrolinsen mit zugeordneten Bildsensoren ermöglicht.

10. Das Verfahren gemäß einem der vorhergehenden Ansprüche, bei dem das Stapeln der Mehrzahl von Mikrolinsen (232) auf die Mehrzahl von Bildsensoren (242) das Kleben der ersten Schicht (220) auf die zweite Schicht (240) aufweist.

11. Das Verfahren gemäß einem der vorhergehenden Ansprüche, bei dem das Befestigen der Mehrzahl von Bildsensoren (242) auf dem flexiblen Substrat (200) ein Verbinden von elektrischen Verbindungen der Bildsensoren mit elektrischen Verbindungen des flexiblen Substrats aufweist.

12. Das Verfahren gemäß einem der vorhergehenden Ansprüche, bei dem das Verfahren nach dem Stapeln der Mehrzahl von Mikrolinsen (232) auf die Mehrzahl von Bildsensoren (242) und dem Befestigen der Mehrzahl von Bildsensoren an dem flexiblen Substrat (200) ferner das Aufbringen des flexiblen Substrats, das die getrennten optischen Kanäle (300) trägt, auf eine gekrümmte Oberfläche (500) aufweist.

13. Das Verfahren gemäß Anspruch 12, bei dem nach dem Aufbringen des flexiblen Substrats (200) auf die gekrümmte Oberfläche (500) Hohlräume (510) zwischen den getrennten optischen Kanälen (300) mit einem Abdichtungsverbundmaterial (520) gefüllt werden.

## Revendications

1. Procédé (100) de fabrication d'un système d'imagerie mécaniquement flexible, le procédé comprenant:
prévoir (110) un substrat flexible (200);
prévoir (110) une première couche (220) comprenant une pluralité de microlentilles (232);
prévoir (110) une deuxième couche (240) comprenant une pluralité de capteurs d'image (242);
empiler (120) la première et la deuxième couche (220; 240) sur le substrat flexible (200) de sorte que chacun de la pluralité de microlentilles (232) et de capteurs d'image (242) soit aligné, pour former une pluralité de canaux optiques (300), chaque canal optique comprenant au moins une microlentille et au moins un capteur d'image associé, où la première et la deuxième couche (220; 240) sont fixées au substrat flexible (200) de sorte que la deuxième couche (240) comprenant la pluralité de capteurs d'image (242) soit fixée au substrat flexible; et
séparer mécaniquement (130) les canaux optiques (300) de sorte que les canaux optiques séparés restent fixés au substrat flexible (200) pour former un système d'imagerie mécaniquement flexible.

2. Procédé selon la revendication 1, dans lequel la prévision du substrat flexible (200) comprend le fait de prévoir une plaquette à circuit imprimé flexible comme support mécanique pour les canaux optiques (300).

3. Procédé selon la revendication 2, dans lequel la prévision de la plaquette à circuit imprimé flexible (200) comprend le fait de prévoir une connexion électrique de la pluralité de capteurs d'image (242) à une électronique de lecture associée via la plaquette à circuit imprimé flexible.

4. Procédé selon l'une des revendications précédentes, dans lequel la pluralité de capteurs d'image (242) sont prévues à l'aide d'une technologie d'intégration à très grande échelle analogique.

5. Procédé selon l'une des revendications précédentes, dans lequel la prévision de la pluralité de capteurs d'image (242) comprend le fait de prévoir des plots de connexion (246) destinés à assembler chacun de la pluralité de capteurs d'image au substrat flexible.

6. Procédé selon l'une des revendications précédentes, dans lequel, pendant l'empilement de la première et de la deuxième couche sur le substrat flexible, l'empilement de la pluralité de microlentilles sur la pluralité de capteurs d'image est effectué avant de fixer la pluralité de capteurs d'image au substrat flexible.

7. Procédé selon l'une des revendications précédentes, dans lequel la prévision de la première et de la deuxième couche (220; 240) comprend respectivement le fait de prévoir des couches planes, et dans lequel l'empilement de la première couche (220) sur la deuxième couche (240), la fixation de la première et de la deuxième couche sur le substrat flexible (200) et la séparation mécanique des canaux optiques (300) s'effectuent à l'état plan.

8. Procédé selon l'une des revendications précédentes, dans lequel la séparation mécanique des canaux optiques (300) comprend le fait de couper, scier, graver, découper en dés, ou découper en dés au laser la première et la deuxième couche empilées, pour séparer physiquement les canaux optiques voisins (300).

9. Procédé selon l'une des revendications précédentes, dans lequel l'empilement de la pluralité de microlentilles (232) sur la pluralité de capteurs d'image (242) comprend le fait de mettre en coïncidence les marques d'alignement prévues antérieurement sur la première et/ou la deuxième couche permettant un alignement exact des microlentilles avec les capteurs d'image associés.

10. Procédé selon l'une des revendications précédentes, dans lequel l'empilement de la pluralité de microlentilles (232) sur la pluralité de capteurs d'image (242) comprend le fait d'assembler par collage la première couche (220) sur la deuxième couche (240).

11. Procédé selon l'une des revendications précédentes, dans lequel la fixation de la pluralité de capteurs d'image (242) au substrat flexible (200) comprend le fait d'assembler les connexions électriques des capteurs d'image avec les connexions électriques du substrat flexible.

12. Procédé selon l'une des revendications précédentes, dans lequel le procédé comprend par ailleurs, après l'empilement de la pluralité de microlentilles (232) sur la pluralité de capteurs d'image (242) et la fixation de la pluralité de capteurs d'image au substrat flexible (200), le fait de monter le substrat flexible portant les canaux optiques séparés (300) sur une surface courbe (500).

13. Procédé selon la revendication 12, dans lequel, après le montage du substrat flexible (200) sur la surface courbe (500), les cavités (510) entre les canaux optiques séparés (300) sont remplies d'un matériau composite de scellage (520).
